# EUROPEAN PATENT APPLICATION

(11) **EP 4 373 242 A1**
(43) Date of publication of application: **22.05.2024**
(21) Application number: 23740550.1
(22) Date of filing: 17.01.2023
(51) Int. Cl.: H10K 85/60, H10K 85/10, H10K 50/11, H10K 71/00, H10K 85/00

(54) **COATING COMPOSITION, ORGANIC LIGHT-EMITTING DEVICE COMPRISING SAME, AND MANUFACTURING METHOD THEREFOR**

(30) Priority: 17.01.2022 KR 20220006600; 17.01.2022 KR 20220006603
(71) Applicant: LG Chem, Ltd., Yeongdeungpo-gu Seoul 07336 (KR)
(72) Inventor: CHOI, Hyunju, Daejeon 34122 (KR); PARK, Hyungil, Daejeon 34122 (KR); LEE, Jaechol, Daejeon 34122 (KR); JEONG, Su Hun, Daejeon 34122 (KR); KIM, Yongwook, Daejeon 34122 (KR)
(74) Representative: Hoffmann Eitle
(86) International application number: PCT/KR2023/000803
(87) International publication number: WO 2023/136707

(57) **Abstract**

The present invention relates to a coating composition, an organic light emitting device including the same, and a method for manufacturing the same.

## Description

### [Technical Field]

This application claims priority to and the benefit of Korean Patent Application Nos. 10-2022-0006600 and 10-2022-0006603 filed in the Korean Intellectual Property Office on January 17, 2022, the entire contents of which are incorporated herein by reference.

The present invention relates to a coating composition, an organic light emitting device including the same, and a method for manufacturing the same.

### [Background Art]

An organic light emission phenomenon is one of the examples of converting an electric current into visible rays through an internal process of a specific organic molecule. The principle of the organic light emission phenomenon is as follows. When an organic material layer is disposed between an anode and a cathode and an electric current is applied between the two electrodes, electrons and holes are injected into the organic material layer from the cathode and the anode, respectively. The electrons and the holes which are injected into the organic material layer are recombined to form an exciton, and the exciton falls down again to the ground state to emit light. An organic light emitting device using the principle may be generally composed of a cathode, an anode, and an organic material layer disposed therebetween, for example, a hole injection layer, a hole transport layer, a light emitting layer, an electron injection layer, and an electron transport layer.

In order to manufacture an organic light emitting device in the related art, a deposition process has been usually used. However, there are problems in that the loss of materials occurs frequently when an organic light emitting device is manufactured by a deposition process and in that it is difficult to manufacture a device having a large area, and to solve these problems, a device using a solution process has been developed.

Therefore, there is a need for the development of a material for a solution process.

### [Detailed Description of the Invention]

### [Technical Problem]

An object of the present invention is to provide an organic light emitting device including two or more blue host materials different from each other.

Another object of the present invention is to provide a method for manufacturing the above-described organic light emitting device.

### [Technical Solution]

An exemplary embodiment of the present invention provides a coating composition including a compound represented by the following Chemical Formula 1, a compound represented by the following Chemical Formula 2, and a solvent,
in which the coating composition is for forming an organic material layer of an organic light emitting device.

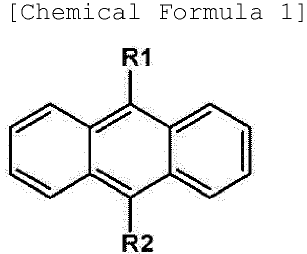

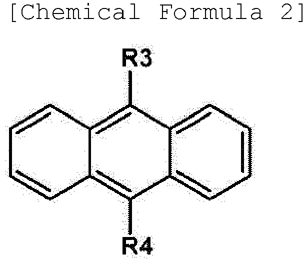

In Chemical Formulae 1 and 2,
R1 and R2 are each a naphthyl group which is unsubstituted or substituted with deuterium,
R3 is a substituted or unsubstituted naphthyl group,
R4 is -(L)ₐ-R41,
L is a substituted or unsubstituted arylene group; or a substituted or unsubstituted heteroarylene group,
R41 is a substituted or unsubstituted naphthyl group,
a is an integer from 1 to 7, and when a is 2 or higher, two or more L's are the same as or different from each other, and
the compound represented by Chemical Formula 1 and the compound represented by Chemical Formula 2 are substituted with one or more deuteriums.

Another exemplary embodiment of the present invention provides a coating composition including two or more host materials different from each other and a solvent,
in which the two or more host materials different from each other each include one or more deuteriums,
the two or more host materials different from each other each have a solubility of 70% or more for the solvent,
the maximum emission peaks of the emission colors of the two or more host materials different from each other are each 380 nm to 500 nm, and
any one host material of the two or more host materials different from each other is included in an amount of 65 parts by weight to 85 parts by weight with respect to 100 parts by weight of the two or more host materials different from each other.

Still another exemplary embodiment of the present invention provides an organic light emitting device including: a first electrode; a second electrode; and an organic material layer having one or more layers provided between the first electrode and the second electrode,
in which the organic material layer having one or more layers includes a light emitting layer, and
the light emitting layer includes the above-described coating composition.

Yet another exemplary embodiment of the present invention provides a method for manufacturing an organic light emitting device, the method including: preparing a first electrode;
forming an organic material layer having one or more layers on the first electrode; and
forming a second electrode on the organic material layer having one or more layers,
in which the forming of the organic material layer having one or more layers includes forming the organic material layer by a solution process using the above-described coating composition.

### [Advantageous Effects]

The organic light emitting device according to the present invention can be manufactured by a solution process.

The organic light emitting device according to the present invention can be obtained with low driving voltage, high efficiency and/or excellent service life characteristics.

### [Brief Description of Drawings]

FIGS. 1 to 3 are views exemplifying the structure of an organic light emitting device according to some exemplary embodiments of the present invention.
FIG. 4 illustrates the solubility of Coating Composition 1 according to Example 1-1 of the present invention.

| | |
|---|---|
| 101: | Substrate |
| 201: | Anode |
| 301: | Hole injection layer |
| 401: | Hole transport layer |
| 501: | Light emitting layer |
| 601: | Electron transport layer |
| 701: | Electron injection layer |
| 801: | Cathode |
| 901: | Capping layer |

### [Best Mode]

Hereinafter, the present invention will be described in detail.

When one member (layer) is disposed "on" another member (layer) in the present invention, this includes not only a case where the one member (layer) is brought into contact with another member, but also a case where still another member (layer) is present between the two members (layers).

When one part "includes" one constituent element in the present invention, unless otherwise specifically described, this does not mean that another constituent element is excluded, but means that another constituent element may be further included.

Hereinafter, the substituents of the present invention will be described in detail.

In the present invention, the term "substitution" means that a hydrogen atom bonded to a carbon atom of a compound is changed into another substituent, and a position to be substituted is not limited as long as the position is a position at which the hydrogen atom is substituted, that is, a position at which the substituent may be substituted, and when two or more substituents are substituted, the two or more substituents may be the same as or different from each other.

In the present invention, the term "substituted or unsubstituted" means being unsubstituted or substituted with one or more substituents selected from the group consisting of deuterium, a halogen group, an alkyl group, a cycloalkyl group, an aryl group and a heteroaryl group, or being unsubstituted or substituted with a substituent to which two or more substituents among the substituents exemplified above are linked. For example, "the substituent to which two or more substituents are linked" may be a biphenyl group. That is, the biphenyl group may also be an aryl group, and may be interpreted as a substituent to which two phenyl groups are linked.

Further, in the present invention, the term "substituted or unsubstituted" means being unsubstituted or substituted with one or more substituents selected from the group consisting of deuterium, a halogen group, an alkyl group having 1 to 30 carbon atoms, a cycloalkyl group having 3 to 30 carbon atoms, an aryl group having 6 to 60 carbon atoms and a heteroaryl group having 2 to 60 carbon atoms, or being unsubstituted or substituted with a substituent to which two or more substituents among the substituents exemplified above are linked.

In the present invention, a halogen group is a fluoro group (-F), a chloro group (-Cl), a bromo group (-Br), or an iodo group (-I).

In the present invention, an alkyl group may be straight-chained or branched, and the number of carbon atoms thereof is not particularly limited, but may be 1 to 30. According to an exemplary embodiment, the number of carbon atoms of the alkyl group is 1 to 20, or 1 to 10. Specific examples of the alkyl group include a methyl group, an ethyl group, an n-propyl group, an isopropyl group, an n-butyl group, an isobutyl group, a tert-butyl group, an n-pentyl group, an n-hexyl group, an n-heptyl group, and the like, but are not limited thereto.

In the present invention, the number of carbon atoms of a cycloalkyl group is not particularly limited, but may be 3 to 60. According to an exemplary embodiment, the number of carbon atoms of the cycloalkyl group is 3 to 30, or 3 to 20. Specific examples of the cycloalkyl group include a cyclopropyl group, a cyclobutyl group, a cyclopentyl group, a cyclohexyl group, a cycloheptyl group, a cyclooctyl group, and the like, but are not limited thereto.

In the present invention, the aryl group may be a monocyclic aryl group or a polycyclic aryl group, and the number of carbon atoms is not particularly limited, but may be 6 to 60. According to an exemplary embodiment, the number of carbon atoms of the aryl group is 6 to 30; or 6 to 20. Examples of the monocyclic aryl group include a phenyl group, a biphenyl group, a terphenyl group, and the like, but are not limited thereto. Examples of the polycyclic aryl group include a naphthyl group, an anthracenyl group, a phenanthrenyl group, a pyrenyl group, a perylenyl group, a triphenylenyl group, a chrysenyl group, a fluorenyl group, and the like, but are not limited thereto.

In the present invention, a fluorenyl group may be substituted, and two substituents may be bonded to each other to form a spiro structure.

When the fluorenyl group is substituted, the substituent may be a substituted fluorenyl group such as a spiro fluorenyl group, a 9,9-dimethylfluorenyl group and a diphenylfluorenyl group. However, the substituent is not limited thereto.

In the present invention, a heteroaryl group is an aromatic cyclic group including one or more of N, 0, P, S, Si, and Se as a heteroatom, and the number of carbon atoms thereof is not particularly limited, but may be 2 to 60. According to an exemplary embodiment, the number of carbon atoms of the heteroaryl group is 2 to 30. Examples of the heteroaryl group include a pyridine group, a pyrrole group, a pyrimidine group, a pyridazine group, a furan group, a thiophene group, a benzothiophene group, a benzofuran group, a dibenzothiophene group, a dibenzofuran group, and the like, but are not limited thereto.

In the present invention, the above-described description on the aryl group is applied to the arylene group except for a divalent arylene group.

In the present invention, the above-described description on the heteroaryl group is applied to the heteroarylene group except for a divalent heteroarylene group.

In the present invention, Tg means glass transition temperature.

In the present invention, Δ(x) means the difference in x between objects to be measured. For example, Δ(Tg) for two materials means the difference in Tg between the two materials.

Hereinafter, a coating composition according to an exemplary embodiment of the present invention will be described.

An exemplary embodiment of the present invention provides a coating composition including a compound represented by the following Chemical Formula 1, a compound represented by the following Chemical Formula 2 and a solvent, in which the coating composition is for forming an organic material layer of an organic light emitting device.

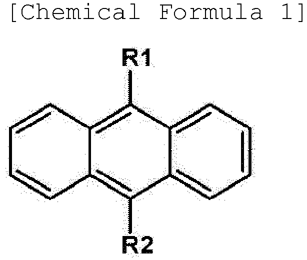

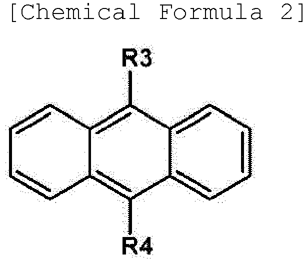

In Chemical Formulae 1 and 2,
R1 and R2 are each a naphthyl group which is unsubstituted or substituted with deuterium,
R3 is a substituted or unsubstituted naphthyl group,
R4 is -(L)ₐ-R41,
L is a substituted or unsubstituted arylene group; or a substituted or unsubstituted heteroarylene group,
R41 is a substituted or unsubstituted naphthyl group,
a is an integer from 1 to 7, and when a is 2 or higher, two or more L's are the same as or different from each other, and
the compound represented by Chemical Formula 1 and the compound represented by Chemical Formula 2 are substituted with one or more deuteriums.

In the present invention, the compounds represented by Chemical Formulae 1 and 2 are structurally different from each other.

When an organic material layer is formed using the coating composition containing the compounds represented by Chemical Formulae 1 and 2 having different structures according to the present invention, the heat treatment temperature in the heat treatment step may be adjusted according to the process. Specifically, when an organic material layer is formed using a single host material or a coating composition including a single host material, the heat treatment temperature needs to be suitable only for the single host material, and when the temperature is out of the range of a suitable heat treatment temperature such as the performance of the heat treatment at a temperature higher than the corresponding heat treatment temperature, there is a disadvantage in that the host material or organic material layer is crystallized. Accordingly, there is a disadvantage in that the heat treatment temperature in the heat treatment step cannot be flexibly adjusted according to the process. Conversely, when an organic material layer is formed using the coating composition containing the compounds represented by Chemical Formulae 1 and 2 having different structures according to the present invention, the heat treatment temperature in the heat treatment step may be flexibly adjusted according to the process. For example, the heat treatment temperature when the organic material layer is formed using the coating composition including the compounds represented by Chemical Formulae 1 and 2 may be adjusted similarly to the heat treatment temperature when an organic material layer is formed using a coating composition including a red host material or the heat treatment temperature when an organic material layer is formed using a coating composition including a green host material.

In addition, when an organic material layer or an organic light emitting device is manufactured using the coating composition including the compounds represented by Chemical Formulae 1 and 2 according to the present invention, the ratio of the parts by weight of the compounds represented by Chemical Formulae 1 and 2 may be flexibly adjusted. Accordingly, when an organic material layer or an organic light emitting device is manufactured using the coating composition including the compounds represented by Chemical Formulae 1 and 2, there are advantages in that by adjusting the proportion of the compounds included in the organic material layer or the organic light emitting device, it is possible to improve film characteristics, optionally adjust the maximum absorption wavelength, improve luminance, and the like, and the heat treatment temperature required in the process can be optionally adjusted as described above.

Furthermore, when the organic material layer is formed using the coating composition including two host materials with different structures according to the present invention, it can be expected that the driving voltage, efficiency and/or service life characteristics, which are device characteristics, are improved.

According to an exemplary embodiment of the present invention, the two host materials with different structures are the compound represented by Chemical Formula 1 and the compound represented by Chemical Formula 2.

According to an exemplary embodiment of the present invention, R1 and R2 are each a naphthyl group which is substituted or unsubstituted with deuterium.

According to an exemplary embodiment of the present invention, L is a substituted or unsubstituted arylene group; or a substituted or unsubstituted heteroarylene group.

According to an exemplary embodiment of the present invention, L is a substituted or unsubstituted arylene group having 6 to 60 carbon atoms; or a substituted or unsubstituted heteroarylene group having 2 to 60 carbon atoms.

According to an exemplary embodiment of the present invention, L is an arylene group having 6 to 60 carbon atoms, which is unsubstituted or substituted with deuterium; or a heteroarylene group having 2 to 60 carbon atoms, which is unsubstituted or substituted with deuterium.

According to an exemplary embodiment of the present invention, L is a substituted or unsubstituted phenylene group; a substituted or unsubstituted naphthylene group; a substituted or unsubstituted divalent anthracene group; a substituted or unsubstituted divalent fluorenyl group; a substituted or unsubstituted divalent dibenzofuran group; or a substituted or unsubstituted divalent dibenzothiophene group.

According to an exemplary embodiment of the present invention, L is a phenylene group which is unsubstituted or substituted with deuterium; a naphthylene group which is unsubstituted or substituted with deuterium; a divalent anthracene group which is unsubstituted or substituted with deuterium; a divalent fluorenyl group which is unsubstituted or substituted with deuterium; a divalent dibenzofuran group which is unsubstituted or substituted with deuterium; or a divalent dibenzothiophene group which is unsubstituted or substituted with deuterium.

According to an exemplary embodiment of the present invention, R41 is a substituted or unsubstituted naphthyl group.

According to an exemplary embodiment of the present invention, R41 is a naphthyl group which is unsubstituted or substituted with any one or more substituents selected from the group consisting of deuterium, a substituted or unsubstituted alkyl group, a substituted or unsubstituted aryl group, and a substituted or unsubstituted heteroaryl group.

According to an exemplary embodiment of the present invention, R41 is a naphthyl group which is unsubstituted or substituted with any one or more substituents selected from the group consisting of deuterium, a substituted or unsubstituted aryl group, and a substituted or unsubstituted heteroaryl group.

According to an exemplary embodiment of the present invention, R41 is a naphthyl group which is unsubstituted or substituted with any one or more substituents selected from the group consisting of deuterium, an aryl group, and a heteroaryl group.

According to an exemplary embodiment of the present invention, R41 is a naphthyl group which is unsubstituted or substituted with deuterium.

According to an exemplary embodiment of the present invention, R41 is a naphthyl group which is unsubstituted or substituted with a substituted or unsubstituted heteroaryl group.

According to an exemplary embodiment of the present invention, R41 is a naphthyl group which is unsubstituted or substituted with a substituted or unsubstituted dibenzofuran group.

According to an exemplary embodiment of the present invention, the compound represented by Chemical Formula 1 is any one selected from the group consisting of the following compounds.

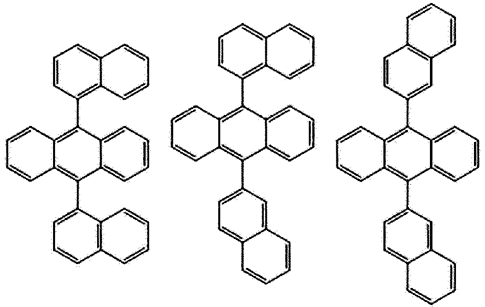

In the compounds, the compounds are substituted with one or more deuteriums.

According to an exemplary embodiment of the present invention, the compound represented by Chemical Formula 2 is any one selected from the group consisting of the following compounds.

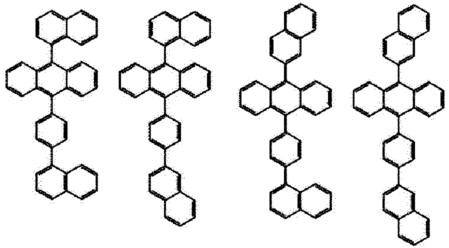

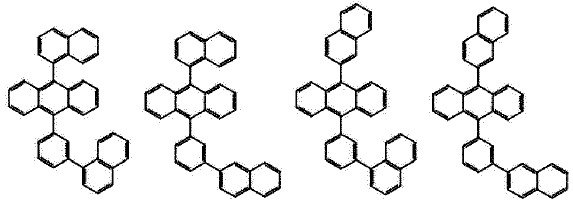

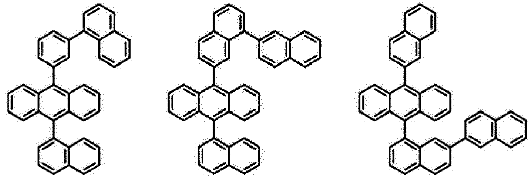

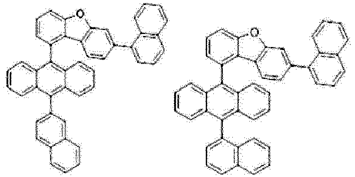

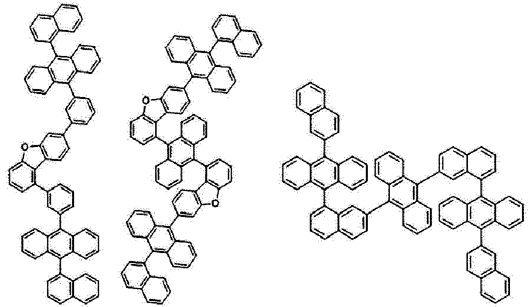

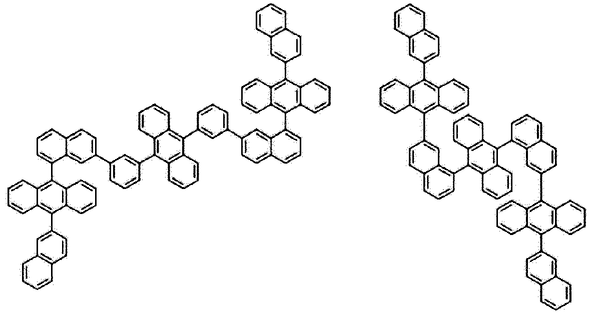

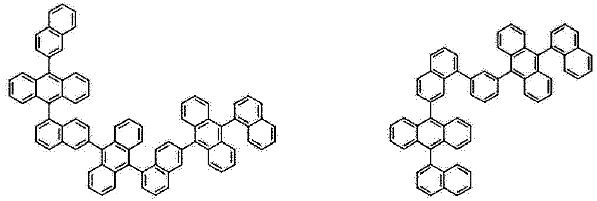

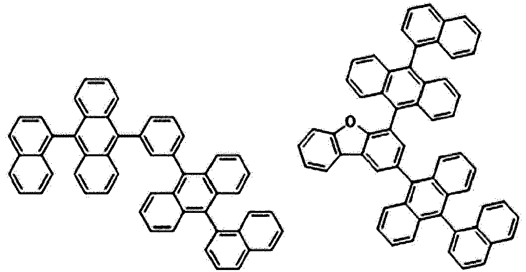

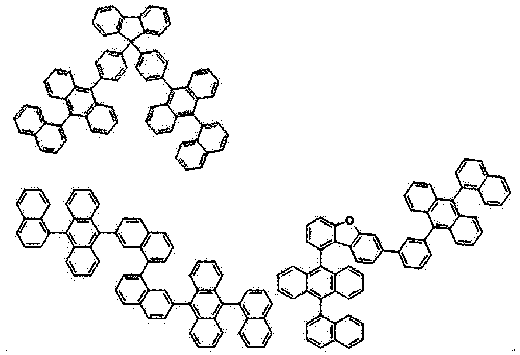

In the compounds, the compounds are substituted with one or more deuteriums.

In the present specification, the substitution of the compound with one or more deuteriums means that at least one hydrogen ("H") is replaced with deuterium ("D"). For example, when the following Compound a-1 is substituted with one or more deuteriums, the compounds may be represented by the following Compound a-2 or a-3.

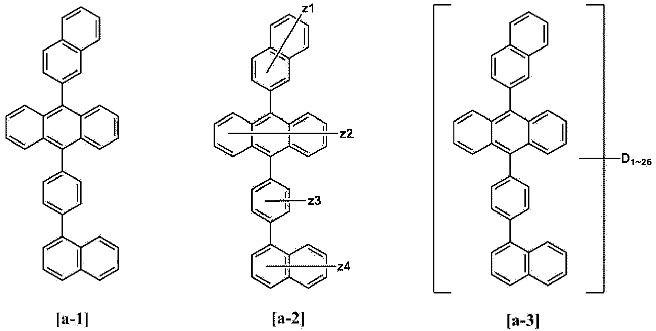

In Chemical Formula a-2, z1 and z4 are each an integer from 0 to 7, z2 is an integer from 0 to 8, z3 is an integer from 0 to 4, and z1+z2+z3+z4 is an integer from 1 to 26.

In the present specification, Dx means being substituted with x deuteriums (D) and D_{x~y} means being substituted with x to y deuteriums. For example, D_{1~26} in Chemical Formula a-3 means being substituted with 1 to 26 deuteriums.

According to an exemplary embodiment of the present invention, the compound represented by Chemical Formula 1 and the compound represented by Chemical Formula 2 are deuterated by 10% or more.

According to an exemplary embodiment of the present invention, at least one of the compound represented by Chemical Formula 1 and the compound represented by Chemical Formula 2 is deuterated by 20% or more. In another exemplary embodiment, at least one of the compound represented by Chemical Formula 1 and the compound represented by Chemical Formula 2 is deuterated by 30% or more. In still another exemplary embodiment, at least one of the compound represented by Chemical Formula 1 and the compound represented by Chemical Formula 2 is deuterated by 40% or more. In yet another exemplary embodiment, at least one of the compound represented by Chemical Formula 1 and the compound represented by Chemical Formula 2 is deuterated by 50% or more. In still yet another exemplary embodiment, at least one of the compound represented by Chemical Formula 1 and the compound represented by Chemical Formula 2 is deuterated by 60% or more. In a further exemplary embodiment, at least one of the compound represented by Chemical Formula 1 and the compound represented by Chemical Formula 2 is deuterated by 70% or more. In another further exemplary embodiment, at least one of the compound represented by Chemical Formula 1 and the compound represented by Chemical Formula 2 is deuterated by 80% or more. In still another further exemplary embodiment, at least one of the compound represented by Chemical Formula 1 and the compound represented by Chemical Formula 2 is deuterated by 90% or more. In yet another further exemplary embodiment, at least one of the compound represented by Chemical Formula 1 and the compound represented by Chemical Formula 2 is deuterated by 100%.

According to an exemplary embodiment of the present invention, the compound represented by Chemical Formula 1 and the compound represented by Chemical Formula 2 are each deuterated by 10% to 100%. In another exemplary embodiment, the compound represented by Chemical Formula 1 and the compound represented by Chemical Formula 2 are each deuterated by 20% to 100%. In still another exemplary embodiment, the compound represented by Chemical Formula 1 and the compound represented by Chemical Formula 2 are each deuterated by 30% to 100%. In yet another exemplary embodiment, the compound represented by Chemical Formula 1 and the compound represented by Chemical Formula 2 are each deuterated by 40% to 100%. In still yet another exemplary embodiment, the compound represented by Chemical Formula 1 and the compound represented by Chemical Formula 2 are each deuterated by 50% to 100%. In a further exemplary embodiment, the compound represented by Chemical Formula 1 and the compound represented by Chemical Formula 2 are each deuterated by 60% to 100%. In another further exemplary embodiment, the compound represented by Chemical Formula 1 and the compound represented by Chemical Formula 2 are each deuterated by 70% to 100%. In still another further exemplary embodiment, the compound represented by Chemical Formula 1 and the compound represented by Chemical Formula 2 are each deuterated by 80% to 100%. In yet another further exemplary embodiment, the compound represented by Chemical Formula 1 and the compound represented by Chemical Formula 2 are each deuterated by 90% to 100%.

In the present invention, the term "deuterated" intends to mean that at least one hydrogen ("H") has been replaced with deuterium ("D"). In deuterated compounds, deuterium is present at least 100-fold the natural abundance level. In some exemplary embodiments, the compound is deuterated by at least 10%. The term "% deuterated" or "% deuteration" means the ratio of deuterium to the sum of proton + deuterium, and is expressed as a percentage.

In the present invention, the deuterated material may be prepared in a similar manner using a deuterated precursor material, or more generally by treating a non-deuterated material with a deuterated solvent, for example, benzene-d6 in the presence of a Lewis acid H/D exchange catalyst, such as trifluoromethanesulfonic acid, aluminum trichloride or ethyl aluminum dichloride.

In the present invention, the "deuteration rate" or "deuterium substitution rate" may be confirmed by a known method such as a nuclear magnetic resonance method (1H NMR), Thin-Layer Chromatography/Mass Spectrometry (TLC/MS), or Gas Chromatography/Mass Spectrometry (GC/MS).

As described above, when deuterium is substituted at the hydrogen position, chemical properties of the compound are almost unchanged. However, since deuterium has twice the atomic weight of hydrogen, physical properties of the deuterated compound change. For example, the deuterated compound has a lower vibration energy level, and a reduction in the vibration energy level may prevent a decrease in intermolecular Van der Waals force and a decrease in quantum efficiency due to collision due to intermolecular vibration. Therefore, a device including deuterated compounds has improved efficiency and service life.

According to an exemplary embodiment of the present invention, the compound represented by Chemical Formula 1 and the compound represented by Chemical Formula 2 are each included at a weight ratio of 15:85 to 85:15.

According to an exemplary embodiment of the present invention, the compound represented by Chemical Formula 1 and the compound represented by Chemical Formula 2 are included at a weight ratio of 65:35 to 85:15, or at a weight ratio of 15:85 to 35:65.

According to an exemplary embodiment of the present invention, the compound represented by Chemical Formula 1 and the compound represented by Chemical Formula 2 are included at a weight ratio of 65:35 to 85:15.

According to an exemplary embodiment of the present invention, the compound represented by Chemical Formula 1 and the compound represented by Chemical Formula 2 are included at a weight ratio of 15:85 to 35:65.

According to a preferred exemplary embodiment of the present invention, when the total parts by weight of the compound represented by Chemical Formula 1 and the compound represented by Chemical Formula 2 is set to 100 parts by weight, the compound represented by Chemical Formula 1 is included in an amount of 15 parts by weight to 35 parts by weight, or 65 parts by weight to 85 parts by weight. As a specific example, the compound represented by Chemical Formula 1 and the compound represented by Chemical Formula 2 are each included at a weight ratio of 15:85 to 35:65, or 65:35 to 85:15.

According to an exemplary embodiment of the present invention, the coating composition includes a larger amount of the compound represented by Chemical Formula 1 than that of the compound represented by Chemical Formula 2.

According to an exemplary embodiment of the present invention, the coating composition includes a larger amount of the compound represented by Chemical Formula 2 than that of the compound represented by Chemical Formula 1.

A device including the compound represented by Chemical Formula 1 and the compound represented by Chemical Formula 2 in the above-described content ratio has a long service life effect. Conversely, when the weight ratio is out of the above range, the service life of the organic light emitting device is shortened.

According to an exemplary embodiment of the present invention, the maximum emission peak of the emission color of the compound represented by Chemical Formula 1 or the compound represented by Chemical Formula 2 is each 380 nm to 500 nm.

According to a preferred exemplary embodiment of the present invention, the maximum emission peaks of the emission colors of the compound represented by Chemical Formula 1 and the compound represented by Chemical Formula 2 are each 380 nm to 500 nm.

In the present invention, the maximum emission peak of 380 nm to 500 nm means that the emission peak having the maximum height is present within 380 nm to 500 nm.

In the present invention, the emission color with a maximum emission peak of 380 nm to 500 nm is blue.

In the present invention, the measurement equipment used to measure the maximum emission peak may be a JASCO FP-8600 fluorescence spectrophotometer or the like. As a specific example, fluorescence intensity and maximum emission peak may be measured at room temperature (about 300 K) by dissolving a material to be measured (compound, coating composition, a part of an organic material layer and/or a part of a device, and the like) using toluene as a solvent to prepare a sample for fluorescence measurement, putting the sample solution into a quartz cell, and then using a fluorescence measurement device. However, the measurement device and measurement conditions for measuring the maximum emission peak may be appropriately changed by those skilled in the art.

In the present invention, a peak refers to a point at which the sign of the slope in the graph changes.

In the present invention, the height of a peak refers to a value obtained by subtracting the current value of the baseline from the current value of the corresponding peak in the cyclic voltammogram.

According to an exemplary embodiment of the present invention, the compound represented by Chemical Formula 1 and the compound represented by Chemical Formula 2 each have a solubility of 70% or more for the solvent.

In regard to the solubility, since the coating composition according to an exemplary embodiment of the present invention is used when a single-layered or multi-layered organic material layer of an organic light emitting device is formed by a solution process, ink stability, or the like is an important factor. Specifically, the solubility of a material in a solvent in the coating composition determines whether the material can be used in an organic light emitting device for a solution process. When the compound represented by Chemical Formula 1 and the compound represented by Chemical Formula 2 included in the coating composition according to an exemplary embodiment of the present invention each have a solubility of 70% or more for the solvent, a single-layered or multi-layered organic material layer of an organic light emitting device may be formed by a solution process. Conversely, when the compound represented by Chemical Formula 1 and the compound represented by Chemical Formula 2 each have a solubility of less than 70% for the solvent, the solution becomes hazy, so that the compounds cannot be used to manufacture an organic light emitting device for a solution process, or the long-term stability remarkably deteriorates even though the compounds are used.

In the present invention, the solubility may be measured at 10°C to 30°C. According to a preferred exemplary embodiment, the solubility may be measured at 15°C to 26°C.

According to an exemplary embodiment of the present invention, the solvent is exemplified as, for example, a chlorine-based solvent such as chloroform, methylene chloride, 1,2-dichloroethane, 1,1,2-trichloroethane, chlorobenzene, and o-dichlorobenzene; an ether-based solvent such as tetrahydrofuran and dioxane; an aromatic hydrocarbon-based solvent such as toluene, xylene, trimethylbenzene, and mesitylene; an aliphatic hydrocarbon-based solvent such as cyclohexane, methylcyclohexane, n-pentane, n-hexane, n-heptane, n-octane, n-nonane, and n-decane; a ketone-based solvent such as acetone, methyl ethyl ketone, cyclohexanone, isophorone, tetralone, decalone, and acetylacetone; an ester-based solvent such as ethyl acetate, butyl acetate, and ethyl cellosolve acetate; a polyhydric alcohol such as ethylene glycol, ethylene glycol monobutyl ether, ethylene glycol monoethyl ether, ethylene glycol monomethyl ether, dimethoxy ethane, propylene glycol, diethoxymethane, triethylene glycol monoethyl ether, glycerin, and 1,2-hexanediol, and derivatives thereof; an alcohol-based solvent such as methanol, ethanol, propanol, isopropanol, and cyclohexanol; a sulfoxide-based solvent such as dimethyl sulfoxide; an amide-based solvent such as N-methyl-2-pyrrolidone and N,N-dimethylformamide; and a solvent such as tetralin, but is not limited thereto.

According to an exemplary embodiment of the present invention, the solvents may be used either alone or in a mixture of two or more solvents.

According to an exemplary embodiment of the present invention, the coating composition is for forming an organic material layer of an organic light emitting device.

According to an exemplary embodiment of the present invention, the coating composition is for forming a single-layered or multi-layered organic material layer of an organic light emitting device.

According to an exemplary embodiment of the present invention, the coating composition is for forming a single-layered organic material layer of an organic light emitting device.

According to an exemplary embodiment of the present invention, the coating composition is for forming a multi-layered organic material layer of an organic light emitting device.

According to an exemplary embodiment of the present invention, the organic material layer is a light emitting layer. That is, the coating composition is for forming a light emitting layer.

According to an exemplary embodiment of the present invention, the difference in HOMO level or LUMO level of the compound represented by Chemical Formula 1 and the compound represented by Chemical Formula 2 is 0.1 eV to 5.0 eV. Specifically, the difference in HOMO level or LUMO level of the compound represented by Chemical Formula 1 and the compound represented by Chemical Formula 2 is 0.1 eV to 4.0 eV, or 0.1 eV to 3.0 eV.

According to an exemplary embodiment of the present invention, the difference in HOMO level of the compound represented by Chemical Formula 1 and the compound represented by Chemical Formula 2 is 0.1 eV to 5.0 eV, 0.1 eV to 4.0 eV, or 0.1 eV to 3.0 eV.

According to an exemplary embodiment of the present invention, the difference in LUMO level of the compound represented by Chemical Formula 1 and the compound represented by Chemical Formula 2 is 0.1 eV to 5.0 eV, 0.1 eV to 4.0 eV, or 0.1 eV to 3.0 eV.

In the present invention, an energy level means a size of energy. Accordingly, even when the energy level is expressed in the negative (-) direction from the vacuum level, it is interpreted that the energy level means an absolute value of the corresponding energy value. For example, the HOMO level (HOMO energy level) means the distance from the vacuum level to the highest occupied molecular orbital. Further, the LUMO level (LUMO energy level) means the distance from the vacuum level to the lowest unoccupied molecular orbital.

In the present invention, the difference in HOMO level and the difference in LUMO level are expressed as absolute values. For example, the difference in HOMO level of the compound represented by Chemical Formula 1 and the compound represented by Chemical Formula 2 is |the HOMO level of the compound represented by Chemical Formula 1 - the HOMO level of the compound represented by Chemical Formula 21, and the value thereof is 0.1 eV to 5.0 eV.

In the present invention, when the light emitting layer is composed of a host-guest system, holes and electrons are injected into the HOMO level and LUMO level of the host material, respectively, to cause Langevin-type recombination, so that excitons are first generated in the host material, excitons are sequentially formed in the dopant material through energy transfer, and as a result, light may be finally emitted from the dopant material. In this case, when the difference in HOMO level or LUMO level of the compound represented by Chemical Formula 1 and the compound represented by Chemical Formula 2 is within the above-described range, the compounds contribute to the light emission of the device, and as a result, the device has excellent light emitting efficiency.

According to an exemplary embodiment of the present invention, the difference in glass transition temperature (Tg) of the compound represented by Chemical Formula 1 and the compound represented by Chemical Formula 2 is 3°C to 30°C. Specifically, the difference in Tg between the compound represented by Chemical Formula 1 and the compound represented by Chemical Formula 2 is 4°C to 30°C, 4°C to 28°C, or 4°C to 10°C.

The difference in Tg is expressed as an absolute value. For example, the difference in glass transition temperature (Tg) of the compound represented by Chemical Formula 1 and the compound represented by Chemical Formula 2 is |the Tg of the compound represented by Chemical Formula 1 - the Tg of the compound represented by Chemical Formula 21, and the value thereof is 4°C to 30°C.

According to an exemplary embodiment of the present invention, the compound represented by Chemical Formulae 1 and 2 are each used as a host. Specifically, the compounds represented by Chemical Formulae 1 and 2 are each used as a light emitting host.

According to an exemplary embodiment of the present invention, the coating composition may further include a light emitting dopant.

Examples of the light emitting dopant material include an aromatic amine derivative, a styrylamine compound, a boron complex, a fluoranthene compound, a metal complex, and the like. Specifically, the aromatic amine derivative is a fused aromatic ring derivative having a substituted or unsubstituted arylamine group, and examples thereof include pyrene, anthracene, chrysene, periflanthene, and the like having an arylamine group. Further, the styrylamine compound is a compound in which a substituted or unsubstituted arylamine is substituted with at least one arylvinyl group, and one or two or more substituents selected from the group consisting of an aryl group, a silyl group, an alkyl group, a cycloalkyl group, and an arylamine group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

The light emitting dopant material may be included in an amount of 0.5 parts by weight to 20 parts by weight, 0.7 parts by weight to 10 parts by weight, or 0.8 parts by weight to 5 parts by weight with respect to 100 parts by weight of the light emitting host material.

According to an exemplary embodiment of the present invention, the coating composition may be in a liquid phase.

According to another exemplary embodiment of the present invention, the coating composition further includes: a single molecule including a photocurable group and/or a thermosetting group; or a single molecule including an end group capable of forming a polymer by heat. As described above, the single molecule including a photocurable group and/or a thermosetting group; or the single molecule including an end group capable of forming a polymer by heat may be a compound having a molecular weight of 3,000 g/mol or less, but the molecular weight is not limited to the exemplified molecular weight.

The single molecule including a photocurable group and/or a thermosetting group; or the single molecule including an end group capable of forming a polymer by heat may mean aryl such as phenyl, biphenyl, fluorene, and naphthalene; arylamine; or a single molecule in which a photocurable group and/or a thermosetting group or an end group capable of forming a polymer by heat is substituted with fluorene.

According to an exemplary embodiment of the present invention, the coating composition has a viscosity of 2 cP to 15 cP at room temperature. When the above viscosity is satisfied, a device is easily manufactured. Specifically, a uniform film may be formed when an organic material layer in an organic light emitting device is formed.

An exemplary embodiment of the present invention provides a coating composition including two or more host materials different from each other and a solvent,
in which the two or more host materials different from each other each include one or more deuteriums,
the two or more host materials different from each other each have a solubility of 70% or more for the solvent,
the maximum emission peaks of the emission colors of the two or more host materials different from each other are each 380 nm to 500 nm, and
any one host material of the two or more host materials different from each other is included in an amount of 65 parts by weight to 85 parts by weight with respect to 100 parts by weight of the two or more host materials different from each other.

According to an exemplary embodiment of the present invention, the two or more host materials different from each other include the above-described compound represented by Chemical Formula 1 and the above-described compound represented by Chemical Formula 2.

According to an exemplary embodiment of the present invention, the coating composition includes two host materials different from each other.

In the coating composition, the description on the solubility and the emission peak is as described above.

Hereinafter, an organic light emitting device according to an exemplary embodiment of the present invention will be described.

An exemplary embodiment of the present invention provides an organic light emitting device including: a first electrode; a second electrode; and an organic material layer having one or more layers provided between the first electrode and the second electrode, in which the organic material layer having one or more layers includes a light emitting layer, and the light emitting layer includes the coating composition.

The organic light emitting device according to an exemplary embodiment of the present invention as described above has a high charge recombination probability, so that excellent light emitting efficiency may be expected. In addition, as two or more blue host materials different from each other are included, there is an advantage in that it is advantageous to secure the process temperature.

According to an exemplary embodiment of the present invention, the two or more blue host materials different from each other include the compound represented by Chemical Formula 1 and the compound represented by Chemical Formula 2.

In the present specification, including the coating composition means including the coating composition or a cured product of the coating composition.

In the present specification, the fact that the light emitting layer includes the coating composition means that the light emitting layer is formed using the coating composition.

Hereinafter, the types of organic material layers included in the above-described organic light emitting device will be specifically described.

The organic material layer having one or more layers includes one or more layers selected from the group consisting of, for example, a hole injection layer; a hole transport layer; a hole injection and transport layer; an electron blocking layer; a light emitting layer; a hole blocking layer; an electron transport layer; an electron injection layer; an electron injection and transport layer, and the like. In this case, the hole injection and transport layer means a layer which simultaneously injects and transports holes. Furthermore, the electron injection and transport layer means a layer which simultaneously injects and transports electrons. However, the organic material layers forming the group are merely an example, and the organic material layer having one or more layers is not limited to the above-described example. Further, the organic material layer having one or more layers may include two or more layers that play the same role, if necessary. The organic light emitting device according to an exemplary embodiment includes a first light emitting layer and a second emitting layer. However, the organic material layer having one or more layers is not limited to the examples.

According to an exemplary embodiment of the present invention, the organic material layer having one or more layers includes a light emitting layer. As an example, the light emitting layer includes the above-described coating composition.

According to an exemplary embodiment of the present invention, the organic material layer having one or more layers further includes an organic material layer having one or more layers in addition to the light emitting layer.

According to an exemplary embodiment of the present invention, the organic material layer having one or more layers further includes an organic material layer having one or more layers selected from the group consisting of a hole injection layer; a hole transport layer; a hole injection and transport layer; an electron injection layer; an electron transport layer; and an electron injection and transport layer, in addition to the light emitting layer.

According to an exemplary embodiment of the present invention, the organic material layer having one or more layers further includes an organic material layer having one or more layers selected from the group consisting of a hole injection layer; a hole transport layer; and a hole injection and transport layer, in addition to the light emitting layer.

According to an exemplary embodiment of the present invention, the organic material layer having one or more layers further includes a first organic material layer in addition to the light emitting layer.

According to an exemplary embodiment of the present invention, the first organic material layer is an organic material layer having one or more layers selected from the group consisting of a hole injection layer; a hole transport layer; and a hole injection and transport layer.

According to an exemplary embodiment of the present invention, the organic material layer having one or more layers further includes an organic material layer having one or more layers selected from the group consisting of an electron injection layer; an electron transport layer; and an electron injection and transport layer, in addition to the light emitting layer.

According to an exemplary embodiment of the present invention, the organic material layer having one or more layers further includes a second organic material layer in addition to the light emitting layer.

According to an exemplary embodiment of the present invention, the second organic material layer is an organic material layer having one or more layers selected from the group consisting of an electron injection layer; an electron transport layer; and an electron injection and transport layer.

According to an exemplary embodiment of the present invention, the organic material layer having one or more layers further includes a first organic material layer and a second organic material layer,
the first organic material layer is provided between the first electrode and the light emitting layer,
the second organic material layer is provided between the second electrode and the light emitting layer,
the first organic material layer is an organic material layer having one or more layers selected from the group consisting of a hole injection layer; a hole transport layer; and a hole injection and transport layer, and
the second organic material layer is an organic material layer having one or more layers selected from the group consisting of an electron injection layer; an electron transport layer; and an electron injection and transport layer.

Hereinafter, the stacking structure of the organic material layer and the organic light emitting device including the organic material layer will be specifically described.

The organic material layer of the organic light emitting device according to an exemplary embodiment of the present invention has a single-layered structure. For example, the organic material layer having the single-layered structure is provided between the first electrode and the second electrode of the organic light emitting device, and the organic material layer includes the above-described coating composition. According to a specific exemplary embodiment, the organic material layer having the single-layered structure is a light emitting layer, and in this case, the light emitting layer includes the above-described coating composition.

The organic material layer of the organic light emitting device according to another exemplary embodiment of the present invention has a multi-layered structure in which an organic material layer having two or more layers is stacked. For example, the organic material layer having the multi-layered structure is provided between the first electrode and the second electrode of the organic light emitting device.

According to an exemplary embodiment of the present invention, the organic material layer having the multi-layered structure includes a light emitting layer and an organic material layer other than the light emitting layer. As an example, the light emitting layer is provided between the first electrode and the second electrode, and the organic material layer other than the light emitting layer is provided between the first electrode and the light emitting layer. As another example, the light emitting layer is provided between the first electrode and the second electrode, and the organic material layer other than the light emitting layer is provided between the light emitting layer and the second electrode. As still another example, the light emitting layer is provided between the first electrode and the second electrode, any one organic material layer other than the light emitting layer is provided between the first electrode and the light emitting layer, and any other organic material layer other than the light emitting layer is provided between the light emitting layer and the second electrode. However, the above structure is merely an example, and the structure is not limited to the above structure. Further, the organic material layer other than the light emitting layer may be one or more layers selected from the group consisting of, for example, a hole injection and transport layer, a hole injection layer, a hole transport layer, an electron blocking layer, a hole blocking layer, an electron transport layer, an electron injection layer, an electron injection and transport layer, and the like, but is not limited thereto.

In general, a hole injection layer, a hole transport layer or an electron blocking layer in an organic light emitting device is provided between an anode and a light emitting layer. As a specific example, the hole injection layer is provided on the anode, the hole transport layer is provided on the hole injection layer, and the electron blocking layer is provided on the hole injection layer, but the present invention is not limited to the above examples.

Further, in general, an electron injection layer, an electron transport layer or a hole blocking layer in an organic light emitting device is provided between a cathode and a light emitting layer. As a specific example, the hole blocking layer is provided on the light emitting layer, the electron transport layer is provided on the hole blocking layer, and the electron injection layer is provided on the electron transport layer, but the present invention is not limited to the above examples.

The organic material layer having a multi-layered structure included in the organic light emitting device according to an exemplary embodiment of the present invention includes: a light emitting layer; and a first' organic material layer having one or more layers selected from the group consisting of a hole injection and transport layer, a hole injection layer, a hole transport layer, an electron blocking layer, a hole blocking layer, an electron transport layer, an electron injection layer, and an electron injection and transport layer, the light emitting layer is provided between a first electrode and a second electrode, and the first' organic material layer having one or more layers is provided between the light emitting layer and the first electrode or between the light emitting layer and the second electrode.

The organic material layer having a multi-layered structure included in the organic light emitting device according to an exemplary embodiment of the present invention includes: a light emitting layer; a first' organic material layer having one or more layers selected from the group consisting of a hole injection layer, a hole transport layer, and an electron blocking layer; and a second' organic material layer having one or more layers selected from the group consisting of an electron injection layer, an electron transport layer, and a hole blocking layer, the light emitting layer is provided between a first electrode and a second electrode, the first' organic material layer having one or more layers is provided between the first electrode and the light emitting layer, and the second' organic material layer having one or more layers is provided between the second electrode and the light emitting layer.

According to an exemplary embodiment of the present invention, the first electrode is an anode, and the second electrode is a cathode.

According to another exemplary embodiment of the present invention, the first electrode is a cathode, and the second electrode is an anode.

According to an exemplary embodiment of the present invention, the organic light emitting device may be a normal type organic light emitting device in which an anode, an organic material layer having one or more layers, and a cathode are sequentially stacked on a substrate.

According to another exemplary embodiment of the present invention, the organic light emitting device may be an inverted type organic light emitting device in which a cathode, an organic material layer having one or more layers, and an anode are sequentially stacked on a substrate.

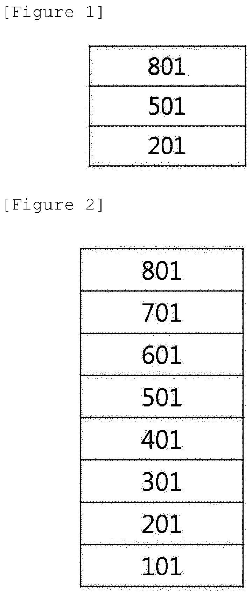

For example, the structure of the organic light emitting device of the present specification may be structures illustrated in FIGS. 1 to 3, but is not limited thereto.

FIG. 1 illustrates an example of an organic light emitting device composed of a first electrode (in this case, an anode) 201, a light emitting layer 501, and a second electrode (in this case, cathode) 801.

FIG. 2 illustrates an example of an organic light emitting device composed of a substrate 101, an anode 201, a hole injection layer 301, a hole transport layer 401, a light emitting layer 501, an electron transport layer 601, an electron injection layer 701, and a cathode 801.

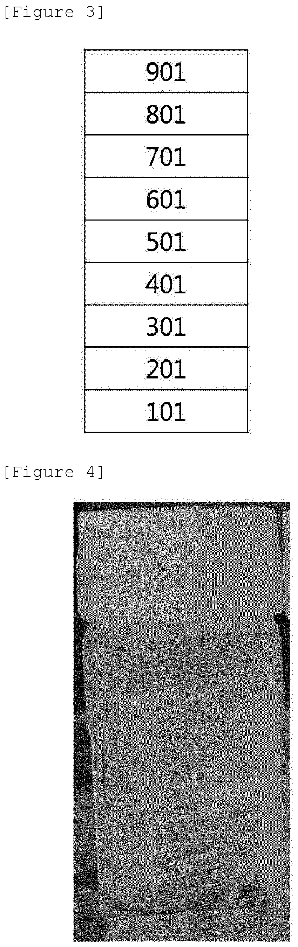

FIG. 3 illustrates an example of an organic light emitting device composed of a substrate 101, an anode 201, a hole injection layer 301, a hole transport layer 401, a light emitting layer 501, an electron transport layer 601, an electron injection layer 701, a cathode 801, and a capping layer 901.

The light emitting layer 501 of FIGS. 1 to 3 includes a coating composition including the two host materials different from each other (the compound represented by Chemical Formula 1 and the compound represented by Chemical Formula 2) and a solvent, or may be formed using the coating composition.

As described above, an organic light emitting device having an organic material layer having a single-layered or multi-layered structure may have, for example, the following stacking structure, but the stacking structure is not limited thereto.
(1) Anode/Hole transport layer/Light emitting layer/Cathode
(2) Anode/Hole injection layer/Hole transport layer/Light emitting layer/Cathode
(3) Anode/Hole injection layer/Hole buffer layer/Hole transport layer/Light emitting layer/Cathode
(4) Anode/Hole transport layer/Light emitting layer/Electron transport layer/Cathode
(5) Anode/Hole transport layer/Light emitting layer/Electron transport layer/Electron injection layer/Cathode
(6) Anode/Hole injection layer/Hole transport layer/Light emitting layer/Electron transport layer/Cathode
(7) Anode/Hole injection layer/Hole transport layer/Light emitting layer/Electron transport layer/Electron injection layer/Cathode
(8) Anode/Hole injection layer/Hole buffer layer/Hole transport layer/Light emitting layer/Electron transport layer/Cathode
(9) Anode/Hole injection layer/Hole buffer layer/Hole transport layer/Light emitting layer/Electron transport layer/Electron injection layer/Cathode
(10) Anode/Hole transport layer/Electron blocking layer/Light emitting layer/Electron transport layer/Cathode
(11) Anode/Hole transport layer/Electron blocking layer/Light emitting layer/Electron transport layer/Electron injection layer/Cathode
(12) Anode/Hole injection layer/Hole transport layer/Electron blocking layer/Light emitting layer/Electron transport layer/Cathode
(13) Anode/Hole injection layer/Hole transport layer/Electron blocking layer/Light emitting layer/Electron transport layer/Electron injection layer/Cathode
(14) Anode/Hole transport layer/Light emitting layer/Hole blocking layer/Electron transport layer/Cathode
(15) Anode/Hole transport layer/Light emitting layer/Hole blocking layer/Electron transport layer/Electron injection layer/Cathode
(16) Anode/Hole injection layer/Hole transport layer/Light emitting layer/Hole blocking layer/Electron transport layer/Cathode
(17) Anode/Hole injection layer/Hole transport layer/Light emitting layer/Hole blocking layer/Electron transport layer/Electron injection layer/Cathode
(18) Anode/Hole injection layer/Hole transport layer/Light emitting layer/Hole blocking layer/Electron transport layer/Electron injection layer/Cathode/Capping layer
(19) Anode/Hole injection layer/First hole transport layer/Second hole transport layer/Light emitting layer/Hole blocking layer/Electron transport layer/Electron injection layer/Cathode/Capping layer

In the structures, the 'Hole injection layer/Hole transport layer' may be replaced with 'Hole injection and transport layer'. Further, the 'Electron transport layer/Electron injection layer' may be replaced with 'Electron injection and transport layer'.

In the organic light emitting device according to an exemplary embodiment of the present invention, the description on the compound represented by Chemical Formula 1, the compound represented by Chemical Formula 2 and the solvent is as described above in the coating composition. For example, the above-described description may be applied in regard to the solubilities of the host materials (the compound represented by Chemical Formula 1 and the compound represented by Chemical Formula 2), the maximum emission peak of the emission color of the host material, the weight ratio, the deuteration rate, the difference in HOMO level, the difference in LUMO level and the difference in Tg.

Hereinafter, the materials for the anode, cathode, and specific organic material layers will be described in detail.

As the anode material, materials having a high work function are usually preferred so as to facilitate the injection of holes into an organic material layer. Examples thereof include: a metal, such as vanadium, chromium, copper, zinc, and gold, or an alloy thereof; a metal oxide, such as zinc oxide, indium oxide, indium tin oxide (ITO), and indium zinc oxide (IZO); a combination of a metal and an oxide, such as ZnO:Al or SnO₂:Sb; a conductive polymer, such as poly(3-methylthiophene), poly[3,4-(ethylene-1,2-dioxy)thiophene] (PEDOT), polypyrrole, and polyaniline; and the like, but are not limited thereto.

As the cathode material, materials having a low work function are usually preferred so as to facilitate the injection of electrons into an organic material layer. Examples thereof include: a metal, such as magnesium, calcium, sodium, potassium, titanium, indium, yttrium, lithium, gadolinium, aluminum, silver, tin, and lead, or an alloy thereof; a multi-layer structured material, such as LiF/Al or LiO₂/Al; and the like, but are not limited thereto.

According to an exemplary embodiment of the present invention, the anode and/or cathode may also be each composed of a triple layer having a stacked structure of ITO/Ag/ITO. In this case, when the first electrode and/or the second electrode are composed of multi layers, voltage drop due to signal delay (RC delay) may be minimized. Accordingly, a desired voltage may be effectively transmitted to the light emitting devices.

A capping layer (CPL) for protecting electrodes may be additionally formed on the cathode, and as a material for the capping layer, a material used in the art may be appropriately used.

The light emitting layer may include a host material and/or a dopant material.

Examples of the host material include a fused aromatic ring derivative, a hetero ring-containing compound, or the like. Specific examples of the fused aromatic ring derivative include anthracene derivatives, pyrene derivatives, naphthalene derivatives, pentacene derivatives, phenanthrene compounds, fluoranthene compounds, and the like, and specific examples of the hetero ring-containing compound include dibenzofuran derivatives, ladder-type furan compounds, pyrimidine derivatives, and the like, but the examples are not limited thereto.

According to an exemplary embodiment of the present invention, as the host material, a mixture of two or more host materials selected from the above-described host materials may be used. Specifically, an anthracene derivative may be used. More specifically, a mixture of the compound of Chemical Formula 1 and the compound of Chemical Formula 2 may be used as the host material.

As the dopant material, the description exemplified in the coating composition may be applied.

The hole injection layer is a layer which accepts holes from an electrode. It is preferred that hole injection material has an ability to transport holes, and has an effect of accepting holes from an anode and an excellent hole injection effect for a light emitting layer or a light emitting material. Further, the hole injection material is preferably a material which is excellent in ability to prevent excitons produced from a light emitting layer from moving to an electron injection layer or an electron injection material. In addition, the hole injection material is preferably a material which is excellent in ability to form a thin film. In addition, the HOMO of the hole injection material is preferably a value between the work function of the anode material and the HOMO of the neighboring organic material layer. Specific examples of the hole injection material include metal porphyrin, oligothiophene, and arylamine-based organic materials; hexanitrile hexaazatriphenylene-based organic materials; quinacridone-based organic materials; perylene-based organic materials; polythiophene-based conductive polymers such as anthraquinone and polyaniline; ytterbium (Yb); dysprosium (Dy), and the like, but are not limited thereto.

The hole transport layer is a layer which accepts holes from a hole injection layer and transports the holes to a light emitting layer, and may have a single-layer structure or a multi-layer structure having two or more layers. A hole transport material is preferably a material having high hole mobility which may accept holes from an anode or a hole injection layer and transfer the holes to a light emitting layer.

The electron transport layer is a layer which accepts electrons from an electron injection layer and transports the electrons to a light emitting layer. An electron transport material is preferably a material having high electron mobility which may proficiently accept electrons from a cathode and transfer the electrons to a light emitting layer. Specific examples thereof include: Al complexes of 8-hydroxyquinoline; complexes including Alq₃; organic radical compounds; hydroxyflavone-metal complexes; and the like, but are not limited thereto. The electron transport layer may be used with any desired cathode material, as used according to the related art. In particular, an appropriate cathode material is a typical material which has a low work function, followed by an aluminum layer or a silver layer. Specific examples thereof include cesium, barium, calcium, ytterbium, and samarium, in each case followed by an aluminum layer or a silver layer.

The electron injection layer is a layer which accepts electrons from an electrode. It is preferred that an electron injection material is excellent in ability to transport electrons and has an effect of accepting electrons from the cathode and an excellent electron injection effect for a light emitting layer or a light emitting material. Further, the electron injection material is preferably a material which prevents excitons produced from a light emitting layer from moving to a hole injection layer and is excellent in ability to form a thin film. Specific examples thereof include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, metal complex compounds, nitrogen-containing 5-membered ring derivatives, and the like, but are not limited thereto. Examples of the metal complex compounds include 8-hydroxyquinolinato lithium, bis(8-hydroxyquinolinato) zinc, bis(8-hydroxyquinolinato) copper, bis(8-hydroxyquinolinato) manganese, tris(8-hydroxyquinolinato) aluminum, tris(2-methyl-8-hydroxyquinolinato) aluminum, tris(8-hydroxyquinolinato) gallium, bis(10-hydroxybenzo[h]quinolinato) beryllium, bis(10-hydroxybenzo[h]quinolinato) zinc, bis(2-methyl-8-quinolinato) chlorogallium, bis(2-methyl-8-quinolinato) (o-cresolato) gallium, bis(2-methyl-8-quinolinato) (1-naphtholato) aluminum, bis(2-methyl-8-quinolinato) (2-naphtholato) gallium, and the like, but are not limited thereto.

The electron blocking layer is a layer which may improve the service life or efficiency of a device by preventing electrons injected from an electron injection layer from passing through a light emitting layer and entering a hole injection layer. A publicly-known electron blocking material may be used as the electron blocking material.

The hole blocking layer is a layer which blocks holes from reaching a cathode, and may be generally formed under the same conditions as those of the electron injection layer. Specific examples of the hole blocking layer material include oxadiazole derivatives or triazole derivatives, phenanthroline derivatives, aluminum complexes, and the like, but are not limited thereto.

The hole injection and transport layer may include materials for the above-described hole injection layer and hole transport layer.

The electron injection and transport layer may include materials for the above-described electron injection layer and electron transport layer.

When the organic light emitting device includes a plurality of organic material layers, the organic material layers may be formed of the same material or different materials.

The organic light emitting device according to the present invention may be a top emission type, a bottom emission type, or a dual emission type according to the material to be used.

Hereinafter, a method for manufacturing an organic light emitting device according to an exemplary embodiment of the present invention will be provided.

An exemplary embodiment of the present invention provides a method for manufacturing an organic light emitting device, in which one or more layers of the organic material layer of the organic light emitting device are formed using the above-described coating composition.

Specifically, an exemplary embodiment of the present invention provides a method for manufacturing an organic light emitting device, the method including: preparing a first electrode; forming an organic material layer having one or more layers on the first electrode; and forming a second electrode on the organic material layer having one or more layers, in which the forming of the organic material layer having one or more layers includes forming the organic material layer by a solution process using the coating composition.

According to an exemplary embodiment of the present invention, the organic light emitting device may be manufactured by materials and methods known in the art, except that the organic material layer having one or more layers is formed of the above-described coating composition. Specifically, the organic light emitting device may be manufactured by materials and methods known in the art, except that the light emitting layer is formed of the above-described coating composition.

In the case of the coating composition according to an exemplary embodiment of the present specification, an organic light emitting device may be manufactured by a solution application method, thereby implementing a large area of the device.

According to an exemplary embodiment of the present invention, the forming of the organic material layer having one or more layers using the coating composition uses a spin coating method.

According to another exemplary embodiment of the present invention, the forming of the organic material layer having one or more layers using the coating composition uses a printing method.

According to an exemplary embodiment of the present invention, examples of the printing method include inkjet printing, nozzle printing, offset printing, transfer printing, screen printing, or the like, but are not limited to the printing methods listed above.

A solution process is suitable for the coating composition according to an exemplary embodiment of the present invention due to the structural characteristics thereof, so that the organic material layer may be formed by a printing method, and as a result, there is an economic effect in terms of time and costs when a device is manufactured.

According to an exemplary embodiment of the present invention, the forming of the organic material layer using the coating composition includes: coating the coating composition on the first electrode or the organic material layer having one or more layers; and drying, heat-treating or light-treating the coated coating composition.

According to an exemplary embodiment of the present invention, the forming of the organic material layer having one or more layers using the coating composition includes: coating the coating composition on the first electrode or the organic material layer having one or more layers; and drying, heat-treating or light-treating the coated coating composition. Preferably, the forming of the organic material layer having one or more layers using the coating composition includes: coating the organic material layer having one or more layers with the coating composition; and drying or heat-treating the coated coating composition. As an example, the forming of the organic material layer having one or more layers using the coating composition includes: coating the first electrode or the organic material layer having one or more layers with the coating composition; and drying the coated coating composition. As another example, the forming of the organic material layer having one or more layers using the coating composition includes: coating the first electrode or the organic material layer having one or more layers with the coating composition; and heat-treating the coated coating composition. As still another example, the forming of the organic material layer having one or more layers using the coating composition includes: coating the organic material layer having one or more layers with the coating composition; drying the coated coating composition; and heat-treating the coating composition.

According to an exemplary embodiment of the present invention, the heat-treating of the coating composition may be performed by heat treatment, and the heat treatment temperature in the heat treatment step may be 80°C to 250°C; 80°C or more and less than 200°C; 100°C to 170°C; or 120°C to 160°C.

According to an exemplary embodiment of the present invention, the heat treatment time in the heat treatment step is 1 minute to 2 hours, may be 1 minute to 1 hour according to an exemplary embodiment, and may be 5 minutes to 1 hour in another exemplary embodiment. As a preferred example, the heat treatment time in the heat treatment step is 5 minutes to 30 minutes.

When the forming of the organic material layer having one or more layers formed using the coating composition includes the heat-treating or light-treating of the coated coating composition, and the coating composition further includes: a single molecule including a photocurable group and/or a thermosetting group; or a single molecule including an end group capable of forming a polymer by heat, an organic material layer including a thin-filmed structure may be provided by forming cross-linkages between components included in the coating composition. In this case, it is possible to prevent the organic material layer from being dissolved, morphologically affected or decomposed by a solvent when another layer is stacked on the surface of the organic material layer formed using the coating composition. Therefore, when the organic material layer is formed by the manufacturing method, resistance to a solvent is increased, so that a plurality of layers may be formed by repeatedly carrying out solution deposition and cross-linking methods, and stability is increased, so that the service life characteristics of the device may be increased.

An exemplary embodiment of the present invention provides an electronic device including an organic light emitting device including the above-described coating composition, or including an organic material layer formed using the above-described coating composition.

The electronic device may include all of the interlayer insulation film of a semiconductor device, a color filter, a black matrix, an overcoat, a column spacer, a passivation film, a buffer coating film, a multilayer printed board insulation film, a cover coat of a flexible copper-clad board, a buffer coating film, a multilayer printed board insulation film, a solder resist film, an insulation film of an OLED, a protection film of a thin-film transistor of a liquid crystal display device, an electrode protection film and a semiconductor protection film of an organic EL device, an OLED insulation film, an LCD insulation film, a semiconductor insulation film, a solar light module, a touch panel, a display device such as a display panel, and the like, but is not limited thereto.

### [Mode for Invention]

Hereinafter, the present invention will be described in detail with reference to Examples for specifically describing the present invention. However, the Examples according to the present invention may be modified into various different forms, and it should not be interpreted that the scope of the present invention is limited to the Examples to be described below. The Examples of the present invention are provided for more completely describing the present invention to a person with ordinary skill in the art.

### <Preparation Examples of Compound>

### Preparation Example 1. Preparation of Compound D

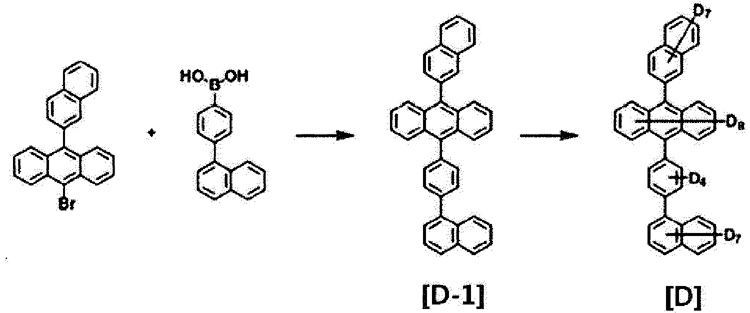

9-bromo-10-(naphthalen-2-yl)anthracene (20 g, 52.2 mmol) and (4-(naphthalen-1-yl)phenyl)boronic acid (14.2 g, 57.4 mmol) were put into 200 mL of a tetrahydrofuran solvent, and the resulting mixture was warmed and stirred. After an aqueous potassium carbonate (14.4 g, 104.3 mmol) solution was added thereto, tetrakis (triphenylphosphine)palladium(0) (1.81 g, 1.56 mmol) was added thereto when distillation started, and the resulting mixture was stirred for additional 3 hours. After the reaction was completed, the resulting product was filtered and then subjected to EtOH slurry distillation to obtain [Compound D-1] (23 g, 87% yield). After [Compound D-1] was dissolved in benzene-d6 in an inert environment, the resulting solution was stirred with trichlorobenzene for 2 hours. The reaction was terminated through D₂O quenching to obtain [Compound D].

The Tg of [Compound D] is 131°C, and the HOMO level and LUMO level of [Compound D] are -5.89 eV and -2.92 eV, respectively. In the reaction scheme, Dn means being substituted with n deuteriums (D), and for example, D₇ means being substituted with 7 deuteriums.

[M + H]⁺ = 533

### Preparation Example 2. Preparation of Compound E

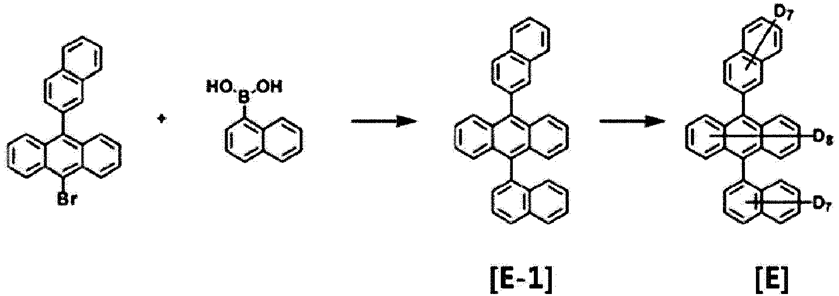

[Compound E] was prepared in the same manner as in Preparation Example 1, except that naphthalen-1-ylboronic acid was used instead of (4-(naphthalen-1-yl)phenyl)boronic acid in Preparation Example 1.

The Tg of [Compound E] is 126°C, and the HOMO level and LUMO level of [Compound E] are -6.00 eV and -3.05 eV, respectively. In the reaction scheme, Dn means being substituted with n deuteriums (D), and for example, D₇ means being substituted with 7 deuteriums.

[M + H]⁺ = 453

### * Absolute value of difference in Tg / absolute value of difference in HOMO level /absolute value of difference in LUMO level between Compounds D and E

△(Tg) : 5°C
**△(HOMO level): 0.11 eV**
**△(LUMO level): 0.13 eV**

### Example 1-1.

The following Compound D and the following Compound E were mixed at a weight ratio of 7:3, and a solvent cyclohexaneone was added thereto to prepare Coating Composition 1. The degree of dissolution of Compound D and Compound E in the solvent cyclohexaneone in Coating Composition 1 prepared above was photographically measured. FIG. 4 illustrates a photograph of measuring the degree of dissolution of Compound D and Compound E in the solvent cyclohexaneone in Example 1-1 of the present application.

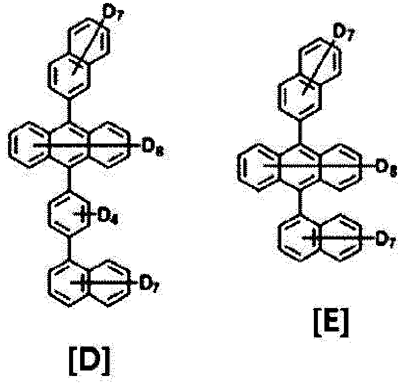

Through FIG. 4, it can be confirmed that Coating Composition 1 is not turbid because Compound D and Compound E show excellent solubility (solubility of 70% or more) for cyclohexaneone which is a solvent. Through this, it can be confirmed that the stability of Coating Composition 1 is excellent.

### <Device Manufacturing Example>

A glass substrate thinly coated with indium tin oxide (ITO)/Ag/ITO to have a thickness of 100 Å, 1200 Å and 80 Å as an anode was put into distilled water in which a detergent was dissolved, and ultrasonically washed. In this case, a product manufactured by the Fischer Co., was used as the detergent, and distilled water twice filtered using a filter manufactured by Millipore Co., was used as the distilled water. After the glass substrate was washed for 30 minutes, ultrasonic washing was conducted twice repeatedly using distilled water for 10 minutes. After being washed with distilled water, the substrate was ultrasonically washed with an isopropyl solvent, dried, and then baked on a hot plate for 10 minutes, and then transported to a glove box.

A hole injection layer (HIL) solution was spin-coated (2500 rpm) on the anode with a mixture of 2.5 wt% cyclohexanone including the following Compound A and the following Compound B at a weight ratio of 8:2, and heat-treated (cured) at 230°C for 30 minutes to form a hole injection layer (HIL) having a thickness of 50 nm. Thereafter, a hole transport layer (HTL) solution was prepared from the following compound C in a 2.1% w/V toluene solvent to form a hole transport layer (HTL) having a thickness of 100 nm on the HIL by spin coating.

Subsequently, an emission layer (EML) having a thickness of 40 nm was formed on the hole transport layer, and in this case, the following Compound D and the following Compound E, which are two blue hosts, were mixed at a weight ratio of 7:3, and a blue dopant Compound F was mixed with cyclohexanone at a ratio of 2 w% in the mixture to prepare an emission layer (EML) coating composition, and the coating composition was spin-coated, and then heat-treated on a hotplate at 150°C for 10 minutes to manufacture a light emitting layer having a thickness of 40 nm. The following Compound G was vacuum-deposited on the light emitting layer, thereby forming an electron transport layer having a thickness of 20 nm. On the electron transport layer, Yb was sequentially deposited to form an electron injection layer having a thickness of 1 nm, and Ag:Mg was deposited to a thickness of 13 nm at a ratio of 9:1 to form a cathode, and finally the following Compound H was applied thereon, thereby forming a capping layer having a thickness of 70 nm.

In the aforementioned procedure, the deposition rate of the organic material was maintained at 0.4 Å/sec to 1.0 Å/sec, the deposition rates of the electron injection layer and the cathode were maintained at 0.1 Å/sec and at 2 Å/sec, respectively, and the degree of vacuum during the deposition was maintained at 2×10⁻⁸ torr to 5×10⁻⁶ torr.

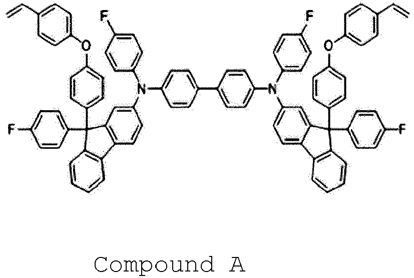

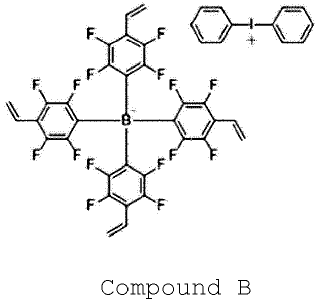

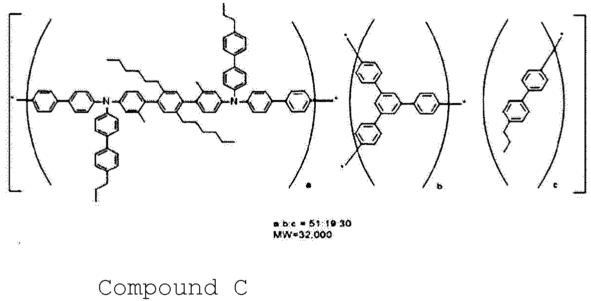

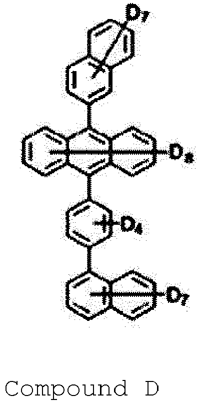

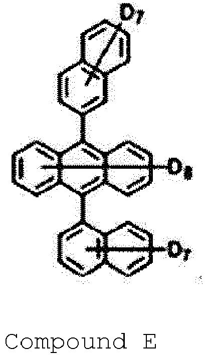

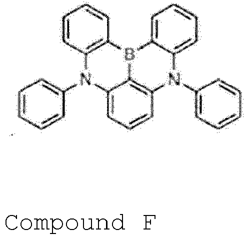

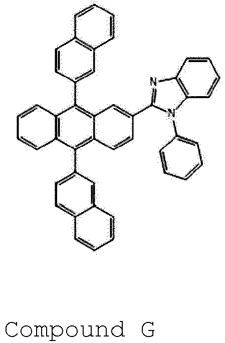

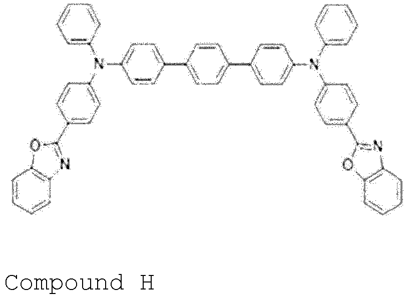

### Example 2-1.

For the organic light emitting device manufactured in the Device Manufacturing Example, the results of measuring the driving voltage, light emitting efficiency, external quantum efficiency and service life at a current density of 10 mA/cm² are shown in the following Table 1. T95 means the time (hr) taken for the luminance to be reduced to 95% of the initial luminance (1000 nit).

### Example 2-2 and Comparative Examples 2-1 to 2-4.

Organic light emitting devices were manufactured in the same manner as in Example 2-1, except that the compounds shown in the following Table 1 were used instead of Compound D and Compound E included in the emission layer (EML) coating composition used during the manufacture of the light emitting layer.

Compounds D-1 and E-1 used in Comparative Examples 2-3 and 2-4, respectively, are as follows.

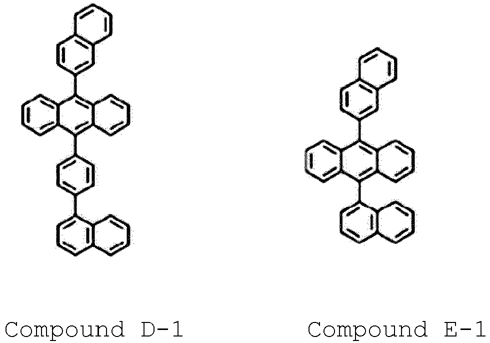

For the organic light emitting device manufactured in each Example or Comparative Example, the results of measuring the driving voltage, light emitting efficiency, external quantum efficiency and service life at a current density of 10 mA/cm² are shown in the following Table 1.

**[Table 1]**

| | Light emitting layer | Heat treatment temperature (°C) | Driving voltage (V) | Light emitting efficiency (cd/A) | Quantum efficiency (%) | T95 (hr) |
|---|---|---|---|---|---|---|
| Example 2-1 | Compound D:Compound E = 7:3 | 145 | 4.09 | 7.16 | 13.24 | 152 |
| Example 2-2 | Compound D:Compound E = 8:2 | 145 | 4.05 | 6.99 | 13.39 | 163 |
| Comparative Example 2-1 | Compound D-1:Compound E-1 = 7:3 | 145 | 4.66 | 6.13 | 13.17 | 128 |
| Comparative Example 2-2 | Compound D-1:Compound E-1 = 8:2 | 145 | 4.56 | 6.09 | 12.99 | 130 |
| Comparative Example 2-3 | Compound D:Compound E = 0:10 | 145 | Experiment impossible due to crystallization | | | |
| Comparative Example 2-4 | Compound D:Compound E = 10:0 | 145 | 4.64 | 5.51 | 11.14 | 61 |
| Comparative Example 2-5 | Compound D-1:Compound E-1 = 0:10 | 45 | Experiment impossible due to crystallization | | | |
| Comparative Example 2-6 | Compound D-1:Compound E-1 = 10:0 | 145 | 4.88 | 5.86 | 11.75 | 50 |

As shown in Table 1, it can be confirmed that in Examples 2-1 and 2-2, in which organic material layers were formed using coating compositions including two host materials different from each other according to the present invention, the driving voltage was reduced and the efficiency and service life characteristics were improved, compared to Comparative Examples 2-1 to 2-6.

Specifically, it can be confirmed that in Examples 2-1 and 2-2, the driving voltage was reduced and the efficiency and service life characteristics were improved by using a coating composition including two blue host materials different from each other, which are substituted with deuterium to form an organic material layer, compared to the case of using a coating composition including two blue host materials different from each other, which are not substituted with deuterium (Comparative Examples 2-1 and 2-2).

In addition, it can be confirmed that in Comparative Examples 2-3 to 2-6, organic material layers were formed using a coating composition which does not include two blue host materials different from each other and includes a single blue host material, thereby leading to deterioration in the driving voltage, efficiency and/or service life characteristics. In particular, in Comparative Examples 2-3 and 2-5, an organic material layer was formed using a coating composition including only Compound E or Compound E-1, but it can be confirmed that the organic layer was crystallized, and thus, the device characteristics deteriorated so much that the voltage, efficiency and service life characteristics could not be measured. Furthermore, in Comparative Examples 2-4 and 2-6, an organic material layer was formed using a coating composition including only Compound D or Compound D-1, but it can be confirmed that there is a disadvantage in that the driving voltage is increased and the efficiency is reduced, and particularly, the service life characteristics greatly deteriorates.

## Claims

1. A coating composition comprising a compound represented by the following Chemical Formula 1, a compound represented by the following Chemical Formula 2 and a solvent,
wherein the coating composition is for forming an organic material layer of an organic light emitting device: 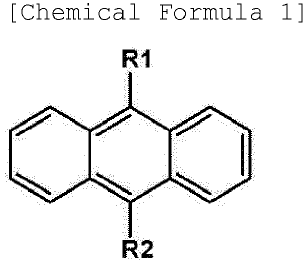 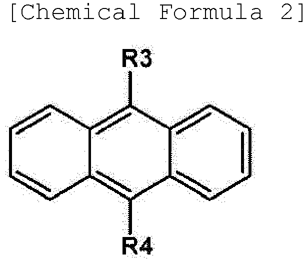
in Chemical Formulae 1 and 2,
R1 and R2 are each a naphthyl group which is unsubstituted or substituted with deuterium,
R3 is a substituted or unsubstituted naphthyl group,
R4 is -(L)ₐ-R41,
L is a substituted or unsubstituted arylene group;
or a substituted or unsubstituted heteroarylene group,
R41 is a substituted or unsubstituted naphthyl group,
a is an integer from 1 to 7, and when a is 2 or higher, two or more L's are the same as or different from each other, and
the compound represented by Chemical Formula 1 and the compound represented by Chemical Formula 2 are each substituted with one or more deuteriums.

2. The coating composition of claim 1, wherein L is a substituted or unsubstituted arylene group having 6 to 60 carbon atoms; or a substituted or unsubstituted heteroarylene group having 2 to 60 carbon atoms.

3. The coating composition of claim 1, wherein the compound represented by Chemical Formula 1 and the compound represented by Chemical Formula 2 each have a solubility of 70% or more for the solvent.

4. The coating composition of claim 1, wherein the compound represented by Chemical Formula 1 is any one selected from the group consisting of the following compounds: 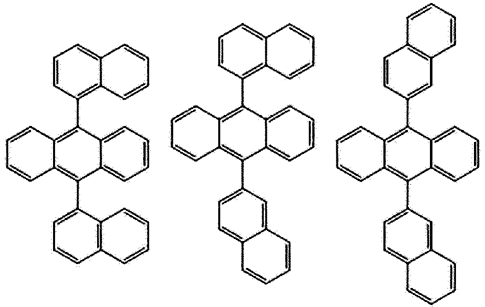 in the compounds, the compounds are substituted with one or more deuteriums.

5. The coating composition of claim 1, wherein the compound represented by Chemical Formula 2 is any one selected from the group consisting of the following compounds: 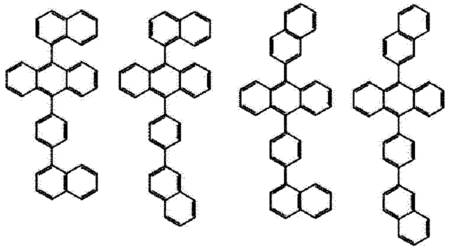 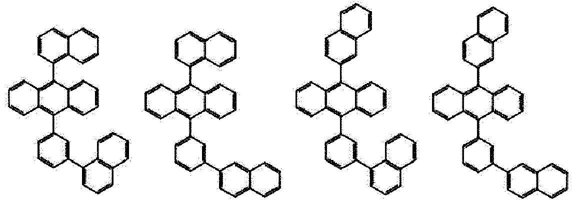 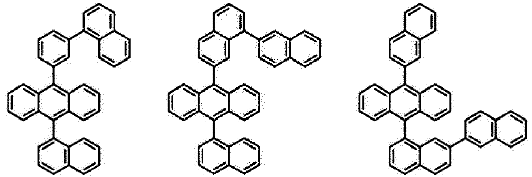 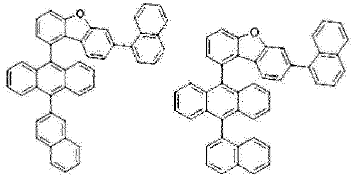 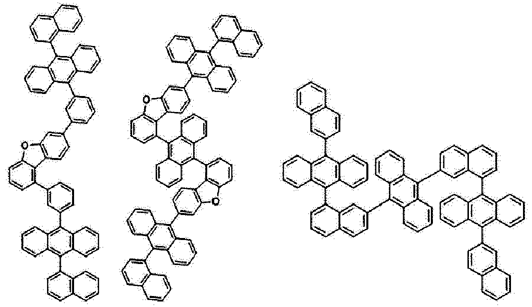 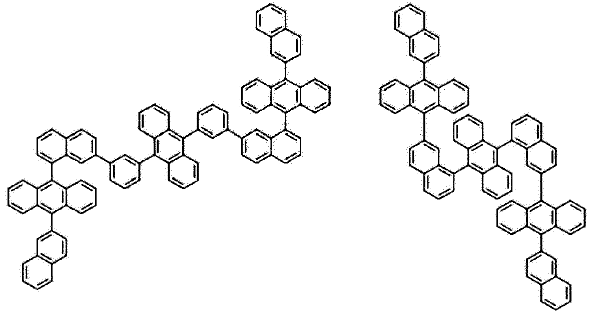 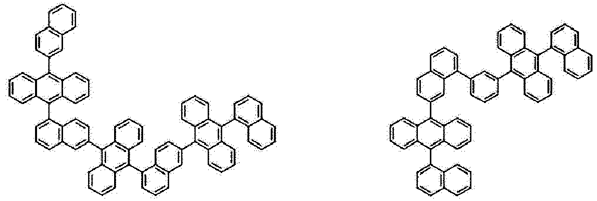 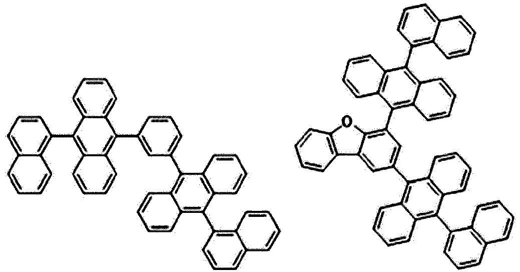 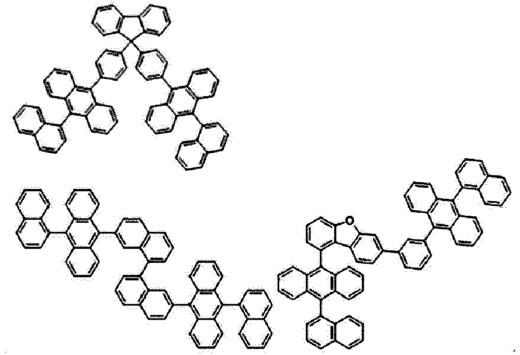 in the compounds, the compounds are substituted with one or more deuteriums.

6. The coating composition of claim 1, wherein the compound represented by Chemical Formula 1 and the compound represented by Chemical Formula 2 are each comprised at a weight ratio of 15:85 to 85:15.

7. The coating composition of claim 1, wherein the organic material layer is a light emitting layer.

8. The coating composition of claim 1, wherein the maximum emission peaks of the emission colors of the compound represented by Chemical Formula 1 and the compound represented by Chemical Formula 2 are each 380 nm to 500 nm.

9. The coating composition of claim 1, wherein the compound represented by Chemical Formula 1 and the compound represented by Chemical Formula 2 are each deuterated by 10% or more.

10. The coating composition of claim 1, wherein a difference in HOMO level or LUMO level of the compound represented by Chemical Formula 1 and the compound represented by Chemical Formula 2 is 0.1 eV to 5.0 eV.

11. The coating composition of claim 1, wherein a difference in glass transition temperature of the compound represented by Chemical Formula 1 and the compound represented by Chemical Formula 2 is 3°C to 30°C.

12. A coating composition comprising two or more host materials different from each other and a solvent,
wherein the two or more host materials different from each other each comprise one or more deuteriums,
the two or more host materials different from each other each have a solubility of 70% or more for the solvent,
the maximum emission peaks of the emission colors of the two or more host materials different from each other are each 380 nm to 500 nm, and
any one host material of the two or more host materials different from each other is comprised in an amount of 65 parts by weight to 85 parts by weight with respect to 100 parts by weight of the two or more host materials different from each other.

13. An organic light emitting device comprising:
a first electrode;
a second electrode; and
an organic material layer having one or more layers provided between the first electrode and the second electrode,
wherein the organic material layer having one or more layers comprises a light emitting layer, and
the light emitting layer comprises the coating composition of any one of claims 1 to 12.

14. The organic light emitting device of claim 13, wherein the organic material layer having one or more layers further comprises an organic material layer having one or more layers selected from the group consisting of a hole injection layer; a hole transport layer; a hole injection and transport layer; an electron injection layer; an electron transport layer; and an electron injection and transport layer.

15. A method for manufacturing an organic light emitting device, the method comprising:
preparing a first electrode;
forming an organic material layer having one or more layers on the first electrode; and
forming a second electrode on the organic material layer having one or more layers,
wherein the forming of the organic material layer having one or more layers comprises forming the organic material layer by a solution process using the coating composition of any one of claims 1 to 12.

16. The method of claim 15, wherein the forming of the organic material layer using the coating composition comprises:
coating the coating composition on the first electrode or the organic material layer having one or more layers; and
drying, heat-treating or light-treating the coated coating composition.

17. The method of claim 16, wherein a heat treatment temperature at the heat treatment step is 80°C to 250°C.
